# EUROPÄISCHE PATENTSCHRIFT

(11) **EP 2 236 455 B1**
(45) Veröffentlichungstag und Bekanntmachung des Hinweises auf die Patenterteilung: **21.10.2015**
(21) Anmeldenummer: 09004887.7
(22) Anmeldetag: 02.04.2009
(51) Int. Cl.: B81B 3/00

(54) **Mikromechanisches Bauteil mit reduziertem Verschleiss**
Micromechanical component with reduced wear
Composant micromécanique avec une usure réduite

(43) Veröffentlichungstag der Anmeldung: 06.10.2010
(73) Patentinhaber: GFD Gesellschaft für Diamantprodukte mbH, 89081 Ulm (DE); Manufacture et fabrique de montres et chronomètres Ulysse Nardin Le Locle S.A., 2400 Le Locle (CH); Diamaze Microtechnology S.A., 2300 La Chaux-de-Fonds (CH)
(72) Erfinder: Dr. Flöter, André, 89081 Ulm (DE); Gretzschel, Ralph, 89081 Ulm (DE); von Gunten, Stéphane, 2400 Le Locle (CH); Dr.- Ing. Gluche, Peter, 2300 La Chaux-de-Fonds (CH)
(74) Vertreter: Pfenning, Meinig & Partner GbR

(56) Entgegenhaltungen:
- RAMAKRISHNAN N; JOHNS E C; YONGJUN ZHAO; KIELY J D; BEDILLION M D; CHU P B ED - DEMARTINI B E; BUTTERFIELD H E; MOEHLIS J; TURNER: "Sliding Contact Micro-Bearing for Nano-Precision Sensing and Positioning" SOLID-STATE SENSORS, ACTUATORS AND MICROSYSTEMS CONFERENCE, 2007. TRANSDUCERS 2007. INTERNATIONAL, IEEE, PISCATAWAY, NJ, USA, 10. Juni 2007 (2007-06-10), Seiten 1689-1692, XP031216376
- LUO J K; FU Y Q; LE H R; WILLIAMS J A; SPEARING S M; MILNE W I: "Diamond and diamond-like carbon MEMS" JOURNAL OF MICROMECHANICS & MICROENGINEERING, INSTITUTE OF PHYSICS PUBLISHING, BRISTOL, GB, Bd. 17, Nr. 7, 1. Juli 2007 (2007-07-01), Seiten S147-S163, XP020120165 ISSN: 0960-1317
- RAMAKRISHNAN N ET AL: "A passive gap-spacing control scheme for in-plane nano-precision sensing and positioning applications", SENSORS AND ACTUATORS A, ELSEVIER SEQUOIA S.A., LAUSANNE, CH, vol. 145-146, 1 July 2008 (2008-07-01), pages 214-223, XP022716436, ISSN: 0924-4247, DOI: 10.1016/J.SNA.2007.12.009 [retrieved on 2007-12-26]

## Beschreibung

Die Erfindung betrifft ein mikromechanisches Bauteil, das mit einem Reibpartner in Kontakt steht, mit einer Abschlussschicht, , die überwiegend aus einem sp²-hybridisiertem -C besteht.

Mikromechanische Bauteile, wie z.B. Uhrwerksbauteile oder auch andere Bauteile, wie Mikrogetriebe, Mikroantriebe, Mikromotoren, Mikrosteller und Mikroaktoren, die mit einem Reibpartner in Kontakt stehen, werden aus verschiedenen Materialien gefertigt, wie z.B. Rubin, Saphir, Messing und Stahl. Teilweise werden dabei auch noch aus Verschleißgründen Verschleißschutzschichten, wie z.B. DLC-Schichten oder Siliciumdioxid, aufgebracht. So wird im Uhwerksbereich für die Ankerpaletten mechanisch polierter, synthetischer Rubin eingesetzt. Das Rad besteht in der Regel aus Stahl. Eine gleiche Materialpaarung wird sehr häufig auch in den Gleitlagern der Achsen eingesetzt. Wobei der Lagerstein aus Rubin oder Saphir besteht und der Gleitlagerzapfen in der Regel aus Stahl. Da der Gleitreibkoeffizient c_{f} dieser und der meisten anderen konventionellen Materialkombinationen sehr hoch ist (c_{f} > 0,2), sowie der damit verbundene Verschleiß sehr hoch ist, benötigen derartige Materialkombinationen immer Schmierstoffe, und zwar spezielle Öle und Fette. Diese Öle/Fette müssen aber auf den Reibflächen gehalten werden, d.h. ein Breitlaufen muss verhindert werden, z.B. durch Herabsetzen der Oberflächenspannung des Festkörpers (Epilamisierung). Es ist jedoch dabei unvermeidlich, dass sich diese Öle mit der Zeit verändern, d.h. sie verdampfen oder verharzen. Weiterhin besteht die Gefahr eines Fremdeinflusses, wie Luftfeuchtigkeit, der die Eigenschaften des Schmierstoffes verändert. Durch diese zwangsläufige Veränderung/Schwund des Schmierstoffes sind insbesondere die Hemm- und Lagerkomponenten im Uhrwerksbereich wartungsanfällig und müssen in regelmäßigen Abständen, d.h. nach 3 bis 5 Jahren, gereinigt und neu geschmiert werden. Eine Veränderung/Schwund der Schmierstoffe hat auch einen Einfluss auf den Wirkungsgrad der Hemmung (d.h. den Energieumsatz und damit die Gangreserve der Uhr) und die Amplitude, d.h. das Schwingungsverhalten des mechanischen Feder-Masseoszillators (Unruh) und damit die Ganggenauigkeit der Uhr.

Es hat deshalb nicht an Versuchen gefehlt, hier durch Verbesserungen Abhilfe zu schaffen.

In den letzten Jahren wurde hierzu deshalb eine Vielzahl neuer Materialkombinationen getestet, insbesondere unter dem Aspekt die Schmierung zu vermeiden (trocken laufende Systeme) und die Komponenten leichter zu gestalten. Die Masse des Hemmrads und des Ankers haben nämlich großen Einfluss auf den Wirkungsgrad der Hemmung, da sie in Abhängigkeit der Schwingfrequenz der Unruh bei jedem Nulldurchgang der Unruh gestoppt und wieder beschleunigt werden müssen. Bei der Auswahl von potentiellen Materialkandidaten für derartige Bauteile wurde deshalb auf ein geringes spezifisches Gewicht geachtet. So kamen Materialien wie Silizium und oxidierten Silizium sowie Diamant zum Einsatz. Auch durch den Einsatz von neuartigen Herstellungstechniken wie dem Plasmaätzen bei Silizium und Diamantbauteilen und der Lithographischen Galvano Abformungstechnik (LIGA) mit Nickelwerkstoffen konnten leichtere Bauteile durch komplexere Geometrien, z.B. das Skelettieren, erreicht werden.

Es hat sich aber gezeigt, dass selbst auch trocken laufende Materialkombinationen Nachteile aufweisen. So hat es sich herausgestellt, dass diese trocken laufenden Materialkombinationen Staub anziehen, welcher sich z.B. im Uhrwerk befindet und meist organischer Natur ist. Diese Staubpartikel gelangen auf die Kontaktflächen und verändern deren Eigenschaften hinsichtlich Verschleiß und Reibung.

In N. Ramakrishnan et al. "Sliding Contact Micro-Bearing for Nano-Precision Sensing and Positioning" in Transducers and Eurosensors 07, the 14th International Conference on Solid-State Sensors, Actuators and Microsystems, Lyon, France, June 10 to 14, 2007 ist ein Modell zur Entwicklung von Grenzflächen mit geringer Reibung und geringer Abrasion zwischen den Reibepartnern beschrieben. Die aus Silizium bestehenden Bauteile werden mit einer Kasten-DLC-Schicht versehen und mit ansonsten gleichen Bauteilen mit einer zusätzlichen weichen DLC-Schicht verglichen. Ausgehend hiervon ist es deshalb die Aufgabe der vorliegenden Erfindung, ein mikromechanisches Bauteil, insbesondere für den Uhrwerksbereich, vorzuschlagen, das mit einem Reibpartner in Kontakt steht, wobei der Wirkungsgrad der Reibpartner erhöht werden soll, d.h. ein kleinstmöglicher Reibkoeffizient c_{f} erreicht werden soll und dass das System eine möglichst kleine Masse der Bauteile aufweist. Ferner sollte der Reibkoeffizient von einer tolerablen Einlaufphase abgesehen konstant sein und sich nicht mit der Zeit verändern. Einflüsse von Luftfeuchtigkeit und der Reibgeschwindigkeit auf den Reibkoeffizienten sollten ebenfalls minimiert werden.

Diese Aufgabe wird durch ein mikromechanisches Bauteil mit den Merkmalen des Anspruchs 1 gelöst. Die Unteransprüche zeigen vorteilhafte Weiterbildungen auf.

Erfindungsgemäß wird ein mikromechanisches Bauteil vorgeschlagen, , das mit einem Reibpartner in Kontakt bringbar ist, umfassend einen Grundkörper (1) sowie eine den Grundkörper (1) abschließende Oberfläche (9) die aus Diamant mit sp3-hybridisiertem Kohlenstoff gebildet ist, wobei auf der Oberfläche (9) eine Abschlussschicht (2) aufgebracht ist, die mit dem Reibpartner in Kontakt bringbar ist,
wobei die Abschlussschicht (2) aus einer Kohlenstoffschicht mit einem gegenüber reinem Diamant erhöhtem Anteil an sp2-hybridisiertem -C gebildet ist, elektrisch leitfähig ist und wobei die Oberfläche (9) eine Terminierung aufweist und/oder zusätzlich Partikel, die die Oberflächenspannung herabsetzen, enthält.

Synthetischer Diamant bzw. Diamantschichten sind kristallin und bestehen hauptsächlich aus sp³-hybridisiertem Kohlenstoff (sp³-C). Es gibt aber in der Regel auch Anteile von sp²-hybridisiertem Kohlenstoff, z.B. an den Korngrenzen. Erfindungsgemäß wird deshalb unter reinem Diamant bzw. Diamantschichten ein Diamant verstanden, der vornehmlich als sp³-hybridisierter kristalliner Kohlenstoff vorliegt. Die Diamantschichten haben eine mittlere Korngröße von etwa 3 bis 100 nm, bevorzugt 10 nm, und eine gemessene Härte (im Nanoindentionsverfahren HIT von etwa 60-110 GPa). Die Härte von Diamant, gemessen nach Vickers, ist » 1000 HV. In der Literatur wurden Werte von - HV 10.000 angegeben.

Die gemäß der Erfindung als Abschlussschicht bezeichneten Schichten weisen gegenüber dem sp³-hybridisierten Kohlenstoff eine ausgesprochen niedrige Härte < 1000 HV 10 auf. Die Abschlussschicht ist dabei nicht zwingend amorph, da sich kleine sp²-hybridisierten -C-Kristalle in der Schicht befinden. Die Abschlussschicht nach der Erfindung kann aber auch rein amorph als sp²-hybridisierte -C-Schicht hergestellt werden.

In Abgrenzung hierzu sind DLC-Strukturen im Wesentlichen amorph und besitzen eine Härte > 1000 HV10.

Mikromechanische Bauteile, die mit einem Reibpartner in Kontakt stehen, können grundsätzlich aus verschiedenen Materialien bzw. Materialkombinationen hergestellt werden. Wie bereits eingangs erläutert, kommen hierfür als Materialien z.B. Rubin, Saphir, Messing, Stahl, Silicium oder auch Diamant in Frage. Bei den gattungsgemäßen Bauteilen, d.h. bei mikromechanischen Bauteilen sind hierbei Diamant und Silicium, das normalerweise an der Oberfläche mit einer dünnen SiO₂-Schicht versehen ist, vorteilhaft.
Die Verwendung von Diamantoberflächen für mikromechanische Bauteile, die mit einem Reibpartner in Kontakt stehen, hat dabei zahlreiche Vorteile. So weist Diamant eine ausgezeichnete mechanische Stabilität, insbesondere eine hohe Bruchspannung und ein hohes E-Modul auf. Dies wirkt sich insbesondere im Uhrwerksbereich vorteilhaft beim Zusammenbau der Uhrwerke aus. Ein weiterer Vorteil der Verwendung von Diamantbauteilen bzw. Bauteilen mit einer Diamantoberfläche liegt darin, dass Diamantbauteile den geringsten Verschleiß aller Materialkombinationen aufweisen, insbesondere wenn beide Reibpartner aus Diamant bestehen. In diesem Fall liegt dann der Reibkoeffizient im Bereich von 0,01 < c_{f} < 0,25, in Abhängigkeit von der Umgebungsbedingung der Rauheit der Diamantoberfläche und der Messparameter. Damit ist der Reibkoeffizient von Diamant vs. Diamant dem klassisch geschmierten Kombinationen von Stahl vs. Rubin, die vom Reibkoeffizient des dazwischen liegenden Ölfilms dominiert wird (Reibkoeffizient 0,12 bis 0,25) überlegen.

Sowohl die Herstellung von mikromechanischen Bauteilen aus Diamant bzw. von Bauteilen, die einen Grundkörper mit Diamantoberfläche aufweisen, wie auch die Herstellung von mikromechanischen Bauteilen mit einer Bauteiloberfläche aus Si bzw. Si mit einer SiO₂-Oberfläche, sind bekannt. Erfindungsgemäß können sowohl mikromechanische Bauteile mit einer Bauteiloberfläche aus Si bzw. auch aus Si mit einer durch Aufoxidation erzeugten Oberfläche aus SiO₂ eingesetzt werden.

Die Herstellung von Bauteilen aus reinem Diamant kann z.B. so vorgenommen werden, wie es in der DE 103 17 889 B4 beschrieben ist. Hierzu wird zuerst eine aus Diamant bestehende Schicht mittels CVD auf einem Substrat abgeschieden und anschließend das Bauteil in seiner Außenkontur mittels eines Ätzschrittes und einer Ätzmaske auf einer ersten Oberfläche der abgeschiedenen ersten Schicht herausgeätzt. Durch die Auswahl geeigneter Prozessparameter und/oder Prozessgase gelingt es, die Selektivität der Ätzraten zwischen Maskenmaterial und der zu ätzenden Schicht sicherzustellen. Dadurch ist es möglich, auch eine im Wesentlichen rechtwinkelige Kante zwischen der Oberfläche der ersten abgeschiedenen Schicht und der Ätzkante auszubilden. Besonders vorteilhaft wird reaktives Ionenätzen verwendet, beispielsweise mittels Chlor oder Sauerstoff. In diesem Zusammenhang wird auf die DE 103 17 889 B4 verwiesen. Ein ähnliches Ätzverfahren mit dem Ziel, eine schräge Schneidkante einer Diamantschneide zu erzeugen, ist in der WO 99/37437 A1 offenbart.

Die Herstellung eines Grundkörpers z.B. aus Si ist ebenfalls bekannt und kann mittels Photolithographie und trockenchemischem Ätzen (Boschprozess) erfolgen. Optional kann auch eine Oxidation der Oberfläche zur Reduktion der Oberflächenrauheit erfolgen. Ferner kann zur Verbesserung der Bauteiloberfläche des mikromechanischen Bauteils aus Si bzw. SiO₂ eine Nukleation mit Diamantnanosuspensionen (Wasser oder alkoholbasierte Lösungen mit Nanodiamantpartikeln, Durchmesser < 100 nm) zur Belegung der Si- bzw. SiO₂-Oberfläche mit Wachstumskeimen erfolgen. Nachfolgend lässt man dann nach bekannten Verfahren, z.B. mittels CVD (chemical vapor deposition), eine Diamantschicht aufwachsen (ca. 0,1 - 10 µm). Auch ist weiterhin noch möglich, eine Plasmapolitur dieser Oberfläche zur Reduktion der Oberflächenrauheit durchzuführen. Mikromechanische Bauteile aus einem Grundkörper mit einer Diamantschicht (sp³-C) als Basis für die Abschlussschicht sind bevorzugt, da dieser Aufbau dem Bauteil eine hohe Schlagfestigkeit, wie sie z.B. bei Schlägen der Uhr auf einen Tisch oder beim Herunterfallen auftritt, verleiht.

Weiterhin hat diese Ausführungsform den Vorteil, dass sie die positiven Eigenschaften des Diamants aufweist. Bei der Erfindung sind dabei Diamantschichten auf einem Grundkörper bevorzugt, die ein E-Modul von 400 bis 1100 GPa, bevorzugt im Bereich von - 700 GPa aufweisen. Die Bruchdehnung gemessen im Biegeversuch liegt dabei bei 1 bis 10 GPa, bevorzugt bei - 4 GPa. Die Diamantschichten sind dabei bevorzugt weiterhin nanokristallin und weisen eine Korngröße von 3 bis 100 nm, bevorzugt ca. 10 nm auf.

Erfindungsgemäß wird nun vorgeschlagen, derartige mikromechanische Bauteile, deren Oberfläche, die mit einem Reibpartner in Kontakt bringbar sind, aus Diamant (sp³-C) besteht, mit einer Abschlussschicht aus Kohlenstoff mit einem gegenüber reinem Diamant (sp³-C) erhöhtem sp²-C-Anteil zu versehen. Dadurch wird nun erreicht, dass diese Abschlussschicht eine geringere Härte aufweist als die darunterliegende Bauteiloberfläche des mikromechanischen Bauteils, die aus Diamant (sp³-C) besteht, so dass es zu einer Selbstschmierung des Systems durch den Härtegradienten kommt. Letztlich wird somit die Reibeigenschaft des erfindungsgemäßen Systems durch die Oberflächenrauheit der Bauteiloberfläche des mikromechanischen Bauteils bestimmt, da durch den gegebenen niederen Härtegrad der Abschlussschicht eine Abrasion dieser Schicht erfolgt. Der Abtrag kann dabei dann nur so weit fortschreiten, bis die unter der Abschlussschicht liegende Oberfläche des mikromechanischen Bauteils, das eine deutlich größere Härte aufweist, erreicht ist.

Ein weiterer Vorteil der Erfindung besteht darin, dass die Abschlussschicht auch eine elektrische Leitfähigkeit aufweist, die das Bauteil wie ein Farradayscher Käfig umgibt und damit die Anziehung von Staub minimiert.

Erfindungsgemäß ist es nun bevorzugt, das mikromechanische Bauteil so auszubilden, dass auf der Bauteiloberfläche entweder eine isolierte Abschlussschicht aus einem überwiegend sp²-hybridisierten -C (sp²-C) aufgebracht ist oder in einer zweiten Alternative, dass eine Abschlussschicht als Gradientenschicht vorgesehen ist, die ausgehend von Diamant (sp³-C) sich in Richtung der Oberfläche zu sp²-hybridisiertem -C ändert. Durch Auswahl der Abscheidebedingungen kann zur Modifizierung der Schicht auch ein erhöhter H₂-Anteil mit eingebaut werden.

Bei der bevorzugten Ausführungsform mit einer Abschlussschicht aus Kohlenstoff mit einer sp²-Hybridisierung besitzt diese eine Schichtdicke, die in Abhängigkeit von der Rauheit der Bauteiloberfläche ausgewählt ist. Bevorzugt wird die Schichtdicke nach der Formel 0,1-10xRz (Rz = Rautiefe) bestimmt. Es ist aber auch möglich, noch dickere Schichten zu verwenden, da das Material durch Abrasion abgetragen wird. Eine derartige sp²-C-Schicht kann vorteilhafterweise z.B. mittels CVD aufgetragen werden. Für den Fall, dass die Bauteiloberfläche aus Diamant besteht, kann mittels CVD die Abschlussschicht leicht durch Adaption der Prozessparameter hergestellt werden.

Wichtig ist, dass die auf der Bauteiloberfläche abgeschiedene Abschlussschicht aus sp² gebundenem Kohlenstoff der Oberflächenrauheit der Bauteiloberfläche folgt. Dadurch, dass nun die sp²-C-Schicht eine deutlich geringere Härte aufweist, als die Bauteiloberfläche, unterliegt sie auch einem entsprechend hohen Verschleiß. Dieser wird selbst-justierend durch die darunter liegende Bauteiloberfläche aus Diamant gestoppt, sobald die Spitzen der Bauteiloberfläche freigelegt sind. Die Täler dienen dann als Reservoir für den Festkörperschmierstoff sp²-Kohlenstoff und der Verschleiß wird durch die Bauteiloberfläche terminiert.

Ein gleicher Effekt kann durch die zweite Alternative der Erfindung realisiert werden, nämlich für den Fall, dass eine Gradientenschicht vorgesehen ist, die im oberflächennahen Bereich in eine reine sp²-Hybridisierung umgebildet worden ist. Durch den graduellen sp²-Anteil weist auch diese Oberfläche einen entsprechenden Härtegradienten auf, der das Einlaufverhalten der Schicht determiniert. Der durch Abrasion hervorgerufene Verschleiß der oberflächennahen sp²-Schicht wirkt dann wieder selbst-justierend ab Erreichen eines gewissen Härtegrades. Die Dicke dieser Schicht liegt im gleichen Bereich wie die der sp²-C-Schicht.

Es hat sich im Versuch gezeigt, dass das erfindungsgemäße Bauteil noch einen weiteren Vorteil aufweist, nämlich dass sich nach einer Einlaufzeit des Reibpartnersystems der Reibkoeffizient sich nochmals verbessert. Dies ist offensichtlich darauf zurückzuführen, dass es nach Abtrag der weicheren sp²-C Schicht zu einer Politur der Spitze der Bauteiloberfläche kommt.

Ein weiterer Vorteil der Abschlussschicht besteht auch darin, dass die Schicht leitfähig ist, so dass eine elektrostatische Anziehung von Staub- und Schmutzpartikeln weitgehend vermieden wird.

Eine weitere Beeinflussung des Reibverhaltens des mikromechanischen Bauteils mit dem Reibpartner kann noch dadurch erreicht werden, dass die Bauteiloberfläche dotiert wird. Die Dotierung dieser Bauteiloberfläche führt zur Vermeidung von elektrostatischen Aufladungen, welche insbesondere organische Kontaminationen anziehen könnten. Dies kann z.B. durch eine Dotierung mit beispielsweise Bor bei Diamant während des Wachstums erreicht werden. Um die Aktivierungsenergie des Dotierstoffes so gering wie möglich zu gestalten, sollte eine Dotierstoffkonzentration von > 5 x 10¹⁹ cm⁻³ gewählt werden. Dadurch ist sichergestellt, dass zumindest Teile des Dotierstoffes schon bei Raumtemperatur ionisiert sind und die Diamantschicht eine elektrische Grundleitfähigkeit aufweist, um elektrostatische Aufladungen zu vermeiden.

Eine weitere Möglichkeit der Beeinflussung der Reibeigenschaften der Partner besteht dadurch, dass eine Terminierung der Bauteiloberfläche des Diamants vorgenommen wird, so dass eine Oberflächenleitfähigkeit entsteht. Dies kann z.B. durch eine H-Terminierung erfolgen, welche nachweislich bei Raumtemperatur eine Oberflächenleitfähigkeit erzeugt.

Letztlich kann auch noch eine herabsetzende Oberflächenspannung vorgenommen werden, und zwar dadurch, dass zusätzlich Partikel in die Bauteiloberfläche eingearbeitet werden und zwar dadurch, dass die Oberflächenspannung durch das Tauchen in fluorhaltigen Flüssigkeiten, sog. Epilamen, herabgesetzt wird. In der Regel wird dies durch Tauchen in fluorbasierte Lösungen erreicht. Dies kann auch bei Diamant erfolgen. Andererseits ist es auch in situ oder durch eine separate Plasmaabscheidung möglich, die Bauteiloberfläche mit einer fluorbasierten Terminierung abzuschließen und so den gleichen Effekt hervorzurufen.

Als Materialien für den Grundkörper sind grundsätzlich Si, Si₃N₄, SiC, Carbide von refraktiven Metallen, wie WC, MoC, TiC und TaC, wie auch Metalle ausgewählt aus Ti, V, Cr, Nb, Mo, Rh, Ta, W, Ir, Pt und Au, wie auch Hartmetalle, z.B. Wolframcarbide geeignet.

Für den Fall, dass ein mikromechanisches Bauteil verwendet wird, das aus reinem Diamant besteht, kann die Abschlussschicht auch so definiert sein, dass diese durch Änderung der Prozessparameter innerhalb des Diamants im oberflächennahen Bereich von einer reinen sp³-Hybridisierung zu einer sp²-Hybridisierung gebildet wird. Die Abschlussschicht in diesem Falle wird somit innerhalb des Diamants durch die vorgegebenen Parameter definiert.

Das Gleiche gilt für den Reibpartner, der ebenfalls ein reines Diamantbauteil oder Si bzw. SiO₂-Bauteil sein kann oder aber ein Bauteil, das wiederum aus einem Grundkörper besteht und dann wiederum an seiner mit dem mikromechanischen Bauteil in Kontakt stehenden Seite eine Diamantschicht aufweist. Betreffend den Grundkörper wird auf die vorstehende Ausführung zum mikromechanischen Bauteil verwiesen.

Das mikromechanische Bauteil nach der Erfindung ist dabei bevorzugt ein Uhrwerksbauteil. Als Beispiele sind hier Hemmbateile (Anker, Ankerrad, Paletten, Plateau, Doppelrolle), Räderwerke, Lagerbauteile (Steine und Zapfen), Instrumentenlager, zeigerwerke und Federn zu nennen. Der Gegenstand der vorliegenden Erfindung umfasst aber nicht nur Uhrwerksbauteile, sondern auch andere mikromechanische Bauteile, wie Mikrogetriebe, Mikroantriebe, Mikromotoren, Mikrosteller, Mikroaktoren, Mikrolager.

Die Erfindung wird nachfolgend anhand von acht Figuren näher erläutert.
Figur 1 zeigt in Figur 1a ausschnittsweise ein erstes mikromechanisches Bauteil nach der Erfindung und in Figur 1b eine vergrößerte Darstellung des gekennzeichneten Bereiches.
Figur 2 zeigt in Figur 2a wiederum ausschnittsweise eine weitere Ausführungsform eines erfindungsgemäßen Bauteils und in Figur 2b eine vergrößerte Darstellung des gekennzeichneten Bereiches.
Figur 3 zeigt eine weitere Ausführungsform nach der Erfindung, wobei wiederum in Figur 3a ausschnittsweise das Bauteil und in Figur 3b eine vergrößerte Darstellung des gekennzeichneten Bereiches abgebildet ist.
Figur 4 zeigt wiederum in Figur 4a eine weitere Ausführungsform eines erfindungsgemäßen mikromechanischen Bauteils und in Figur 4b eine vergrößerte Darstellung des gekennzeichneten Bereiches.
Figur 5 zeigt in Figur 5a ein weiteres mikromechanisches Bauteil nach der Erfindung und in Figur 5b wiederum ausschnittsweise eine vergrößerte Darstellung des gekennzeichneten Bereiches.
Figur 6 zeigt in vergrößerter Darstellung in der Figurenfolge 6b bis 6e die Oberflächenbeschaffenheit von dem in Figur 6a gekennzeichneten Bereich.
Figur 7 zeigt eine Zusammenstellung der wichtigsten Prozessparameter für die Herstellung der Abschlussschichten.
Figur 8 zeigt Messergebnisse für die Rorngrößenverteilung der Diamantschicht.

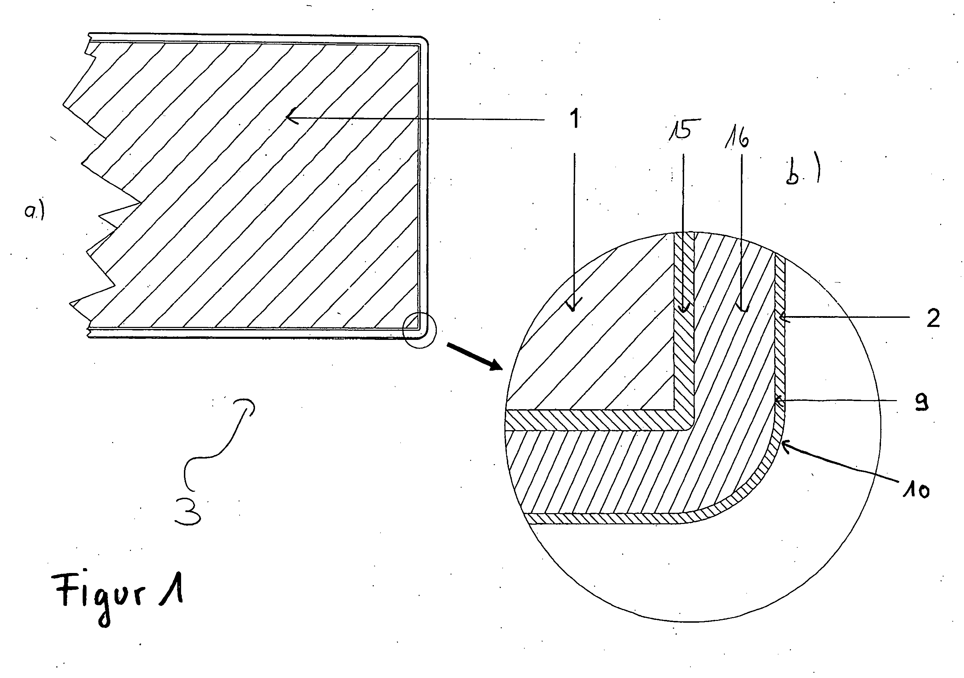

In Figur 1a ist ausschnittsweise ein mikromechanisches Bauteil 3 dargestellt, das aus einem Silicium-Grundkörper 1 sowie einer aufoxidierten Siliciumdioxidschicht 15 (siehe Figur 1b) besteht. Die aufoxidierte Siliciumdioxidschicht weist üblicherweise eine Schichtdicke von 0,2 bis 1,5 µm auf. Auf diesen Grundkörper ist nun eine Diamantschicht 16 aus sp³-hybridisiertem Kohlenstoff, die normalerweise eine Schichtdicke von 5 µm aufweist, aufgebracht. Die Diamantschicht kann dabei aus nanokristallinem Diamant bestehen.

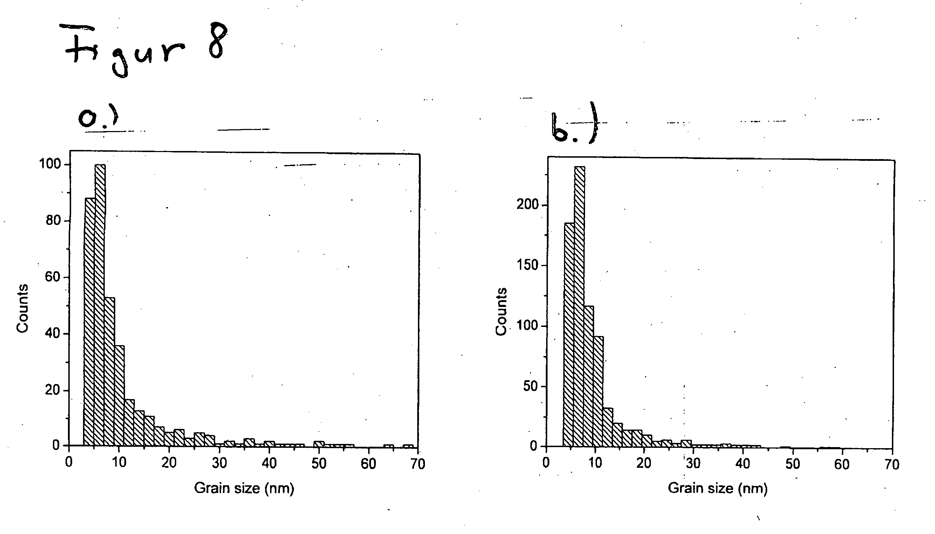

Die Diamantschicht 16 ist im Beispielsfall nanokristallin und weist eine mittlere Korngröße von ca. 10 nm mit statistischer Orientierung auf. In Figur 8 ist eine typische Korngrößenverteilung von zwei Diamantschichten (ermittelt an TEM-Aufnahmen) dargestellt, wonach die mittlere Korngröße bei 11 nm (Figur 8a) bzw. 10 nm (Figur 8b) liegt. Die Oberflächenrauheit rms liegt bei 16 bis 18 nm. Der E-Modul der Diamantschicht liegt im Bereich von 400 bis 1000 GPa, bevorzugt im Bereich von 700 GPa.

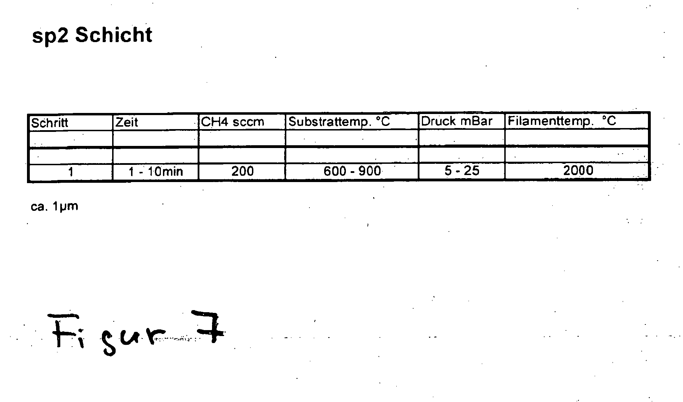

Das mikromechanische Bauteil 3 ist nun erfindungsgemäß auf der Bauteiloberfläche 9 mit einer Abschlussschicht 2 mit einer äußeren Oberfläche 10 versehen. Die Abschlussschicht 2 besteht dabei aus vornehmlich sp²-hybridisiertem Kohlenstoff und weist je nach Oberflächenrauheit eine Dicke von 0,1 bis 10 µm auf. Die Verfahrensparameter zur Herstellung der Schicht 2 sind in Figur 7 angegeben.

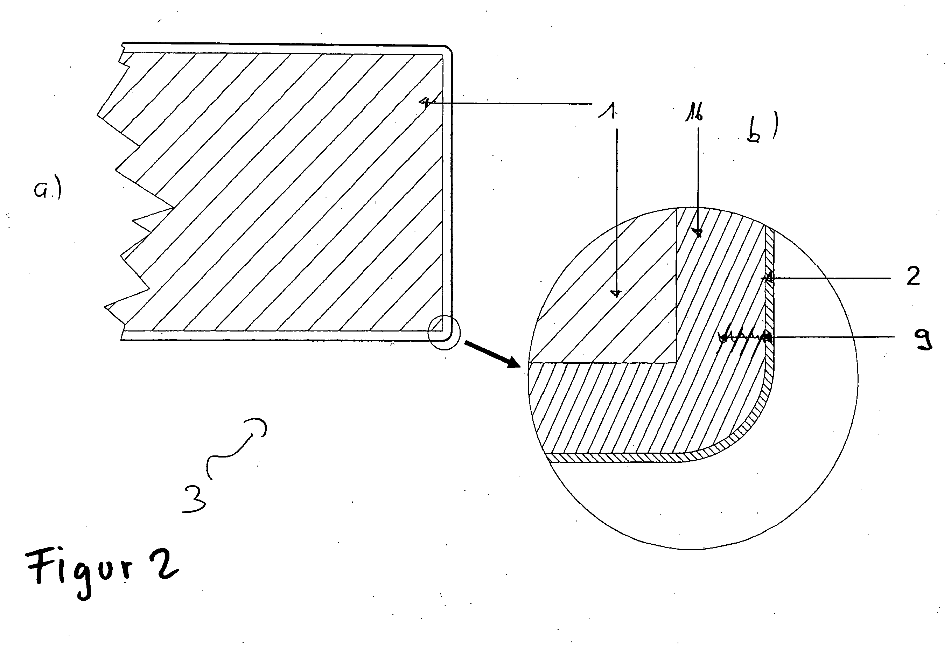

In Abwandlung von der in Figur 1 gezeigten Ausführungsform besteht das mikromechanische Bauteil 3, wie es in der Figur 2 gezeigt ist, aus einem reinen Grundkörper 1 aus Silicium. Dieser Grundkörper 1 aus Silicium ist analog der Ausführungsform nach Figur 1 mit einer Diamantschicht 16, die wiederum wegen der geringen Oberflächenrauheit nanokristallin ist, versehen. Die Diamantschicht 16 aus sp³-hybridisiertem Kohlenstoff weist wiederum eine Dicke von ca. 5 µm auf. Auf der Bauteiloberfläche 9 ist nun wieder analog der Ausführungsform nach Figur 1 eine Abschlussschicht 2 aus sp²-hybridisiertem Kohlenstoff mit einer Schichtdicke von 0,1 bis 10 µm je nach Oberflächenrauheit aufgebracht.

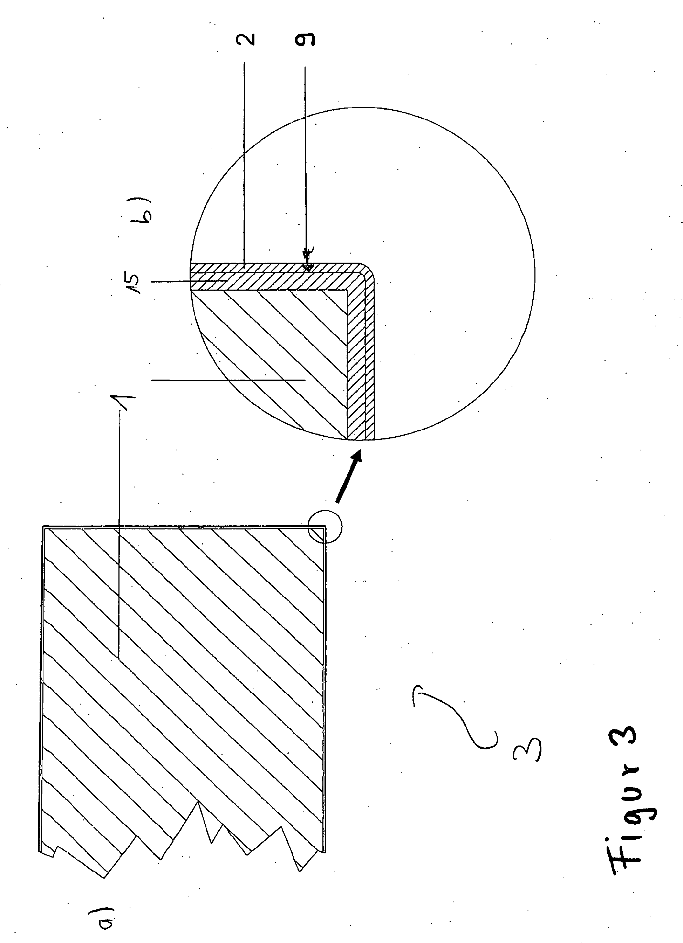

In den Figuren 3a und 3b ist eine weitere Variante eines erfindungsgemäßen mikromechanischen Bauteils 3 gezeigt. Das mikromechanische Bauteil 3 ist dabei ausschließlich aus einem Silicium-Grundkörper 1 aufgebaut und besitzt eine aufoxidierte Siliciumdioxidschicht 15, die eine Schichtstärke von 0,2 bis 1,5 µm aufweist. Erfindungsgemäß ist nun auf der Bauteiloberfläche 9, d.h. auf der SiO₂-Schicht, eine Abschlussschicht 2, wiederum aus sp²-hybridisiertem Kohlenstoff mit einer Schichtdicke von 0,1 bis 10 µm aufgebracht.

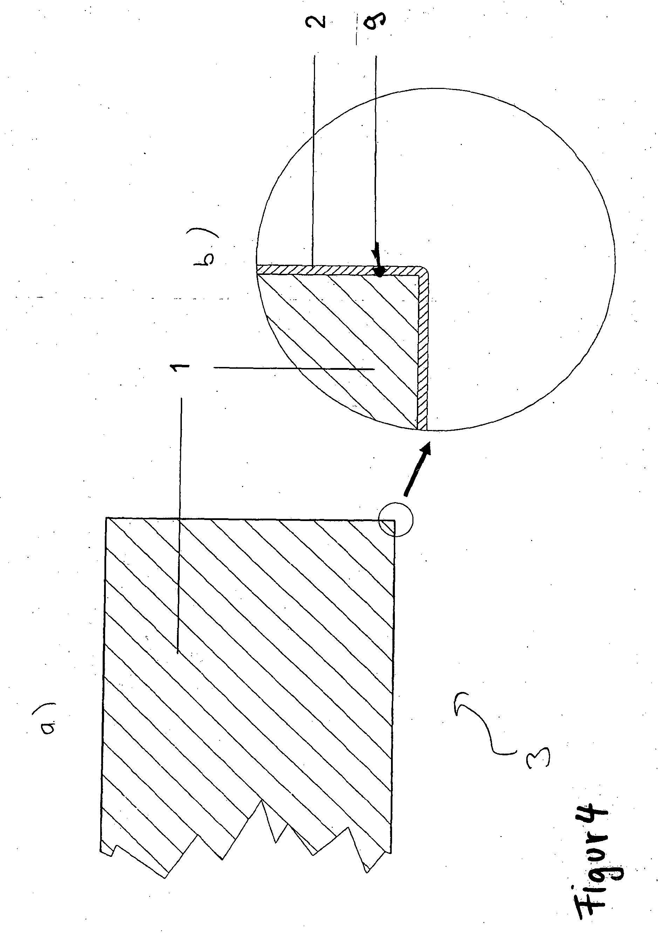

In den Figuren 4a und 4b ist eine weitere Abwandlung eines erfindungsgemäßen mikromechanischen Bauteils 3 gezeigt.

Dieses Bauteil besteht wiederum lediglich aus einem Silicium-Grundkörper 1 und weist auf dessen Bauteiloberfläche 10 eine Abschlussschicht 2 aus sp²-hybridisiertem Kohlenstoff, wiederum mit einer Schichtdicke von 0,1 bis 10 µm, auf.

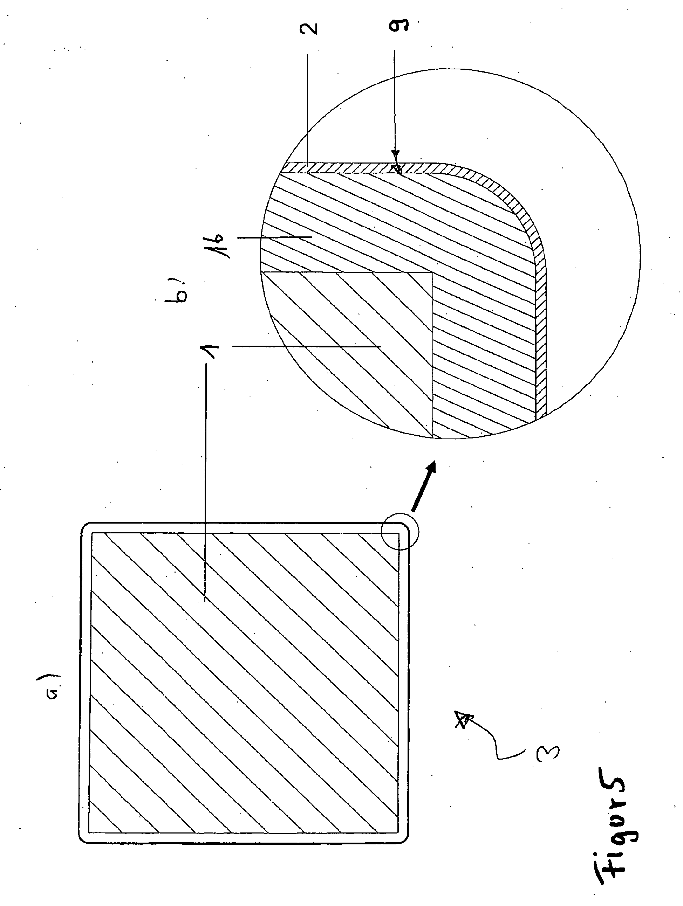

Figur 5 zeigt nun wiederum eine Ausführungsform, wie sie bereits bei der Figur 2 beschrieben worden ist, jedoch ist in Figur 5 das komplette Bauteil abgebildet. Der Silicium-Grundkörper 1 des mikromechanischen Bauteils 3 ist somit dreidimensional, d.h. vollständig von einer Diamantschicht 16 (sp³-hybridisierter Kohlenstoff) umschlossen. Die Diamantschicht kann eine Dicke von 100 nm bis 10 µm haben. Die Dicke der Diamantschicht im Beispielfall beträgt 20 µm. Diese Ausführungsform zeichnet sich insbesondere dadurch aus, dass eine hohe mechanische Stabilität des Bauteils erreicht wird, d.h. eine geringe Bruchanfälligkeit.

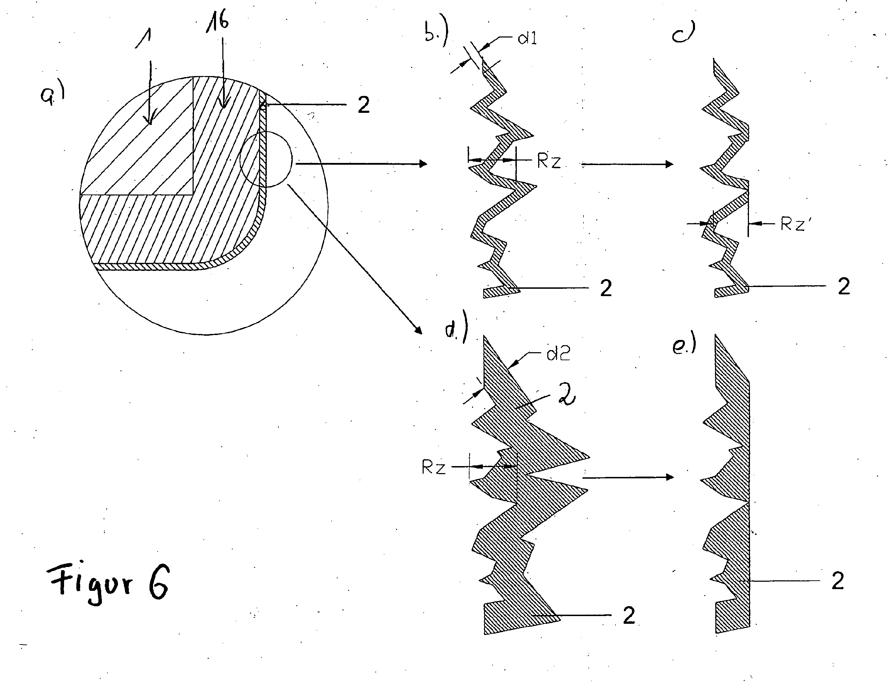

In Figur 6 ist schematisch gezeigt, wie sich das erfindungsgemäße mikromechanische Bauteil 3, und zwar hier die Abschlussschicht 2, beim Einlaufen verhält.

In Figur 6a ist dabei wiederum ausschnittsweise in vergrößerter Darstellung ein Teil eines erfindungsgemäßen mikromechanischen Bauteils gezeigt, wie es bereits in der Figur 2 beschrieben worden ist. Dieses mikromechanische Bauteil besteht dabei aus einem Silicium-Grundkörper 1, auf dem eine Diamantschicht 16 aus sp³-hybridisiertem Kohlenstoff aufgebracht ist. Als Abschlussschicht 2 auf der Diamantoberfläche 9 fungiert eine sp²-hybridisierte Kohlenstoffschicht.

Je nach Schichtstärke der Kohlenstoffschicht sind nun grundsätzlich zwei Fallkonstellationen denkbar.

In der Figurenfolge 6b bis 6c ist schematisch das Einlaufverhalten dargestellt, und zwar für den Fall, dass die sp²-Schicht dünner ist als die Rautiefe (Rz), d.h. d1 < Rz. In diesem Falle wird, wie in Figur 6c gezeigt ist, eine Planarisierung der Oberfläche erreicht. Dies ist in der Figur 6c durch die abgeflachten Spitzen dargestellt.

In Figur 6d ist nun eine sp²-Schicht dargestellt, die dicker ist als die Rautiefe Rz, d.h. d2 > Rz. In diesem Falle, d.h. wenn die sp²-C-Schicht dicker ist als die Rautiefe Rz, kommt es beim Einlaufen zu einer nahezu vollständigen Einebnung der Oberfläche. überschüssiges Material aus der sp²-Schicht kann weg geschoben werden, da die Schicht weich ist. Dieses weg geschobene Material sammelt sich dann in den Vertiefungen an und es bildet sich eine planare äußere Oberfläche.

Es hat sich gezeigt, dass insbesondere diese Ausführungsform, d.h. eine Ausführungsform für die Fallkonstellation, bei der die sp²-Schicht dicker ist als die Rautiefe, bevorzugt ist.

## Patentansprüche

1. Mikromechanisches Bauteil (3), das mit einem Reibpartner in Kontakt bringbar ist, umfassend einen Grundkörper (1) sowie eine den Grundkörper (1) abschließende Oberfläche (9) die aus Diamant mit sp³-hybridisiertem Kohlenstoff gebildet ist, wobei auf der Oberfläche (9) eine Abschlussschicht (2) aufgebracht ist, die mit dem Reibpartner in Kontakt bringbar ist,
wobei die Abschlussschicht (2) aus einer Kohlenstoffschicht mit einem gegenüber reinem Diamant erhöhtem Anteil an sp²-hybridisiertem -C gebildet ist, elektrisch leitfähig ist und wobei die Oberfläche (9) eine Terminierung aufweist und/oder zusätzlich Partikel, die die Oberflächenspannung herabsetzen, enthält.

2. Mikromechanisches Bauteil (3) nach Anspruch 1, **dadurch gekennzeichnet, dass** die Abschlussschicht (2) aus überwiegend sp²-hybridisiertem -C besteht.

3. Mikromechanisches Bauteil (3) nach Anspruch 1, **dadurch gekennzeichnet, dass** die Abschlussschicht (2) eine Gradientenschicht ist, die ausgehend von reinem Diamant sich in Richtung der äußeren Oberfläche (10) der Abschlussschicht (2) zu einem überwiegend sp²-hybridisierten -C ändert.

4. Mikromechanisches Bauteil (3) nach mindestens einem der Ansprüche 1 bis 3, **dadurch gekennzeichnet**, die Abschlussschicht (2) eine Vickers-Härte HV 10 < 9,8 x 10³ N/mm² aufweist.

5. Mikromechanisches Bauteil (3) nach mindestens einem der Ansprüche 1 bis 4, **dadurch gekennzeichnet, dass** die Oberfläche (9) zusätztich dotiert, bevorzugt bordotiert ist.

6. Mikromechanisches Bauteil (3) nach mindestens einem der Ansprüche 1 bis 5, **dadurch gekennzeichnet, dass** die Terminierung eine H-Terminierung ist.

7. Mikromechanisches Bauteil (3) nach mindestens einem der Ansprüche 1 bis 6, **dadurch gekennzeichnet, dass** die Oberfläche (9) eine Rauhigkeit Rms von 5 nm bis 500 nm aufweist.

8. Mikromechanisches Bauteil (3) nach einem der vorhergehenden Ansprüche, **dadurch gekennzeichnet, dass** der Grundkörper (1) aus Si besteht.

9. Mikromechanisches Bauteil (3) nach mindestens einem der vorhergehenden Ansprüche, **dadurch gekennzeichnet, dass** der Diamant ein E-Modul von 400 bis 1200 GPa und/oder eine Bruchdehnung im Biegebruchversuch von 1 bis 10 GPa aufweist.

10. Mikromechanisches Bauteil (3) nach einem der vorhergehenden Ansprüche, **dadurch gekennzeichnet, dass** der Diamant nanokristallin ist und eine mittlere Korngröße von 3 bis 100 nm aufweist.

11. Mikromechanisches Bauteil nach mindestens einem der Ansprüche 1 bis 10, **dadurch gekennzeichnet, dass** es ein Uhrwerksbauteil ist.

12. Mikromechanisches Bauteil nach Anspruch 11, **dadurch gekennzeichnet, dass** das Bauteil ein Lagerbauteil, Räderwerk, Hemmbauteil, Feder, Mikrokugellager, Instrumentenlager eines Uhrwerks ist.

13. Mikromechanisches Bauteil nach mindestens einem der Ansprüche 1 bis 10, **dadurch gekennzeichnet, dass** es ein Mikrogetriebe, Mikroantrieb, Mikrometer, Instrumentenlager, Mikrosteller oder ein Mikroaktor ist.

## Claims

1. Micromechanical component (3) which can be brought into contact with a friction partner, comprising a basic body (1) and also a surface (9) which coats the basic body (1) and is formed from diamond with sp³-hybridised carbon, a top layer (2) being applied on the surface (9), which top layer can be brought into contact with the friction partner,
the top layer (2) being formed from a carbon layer with an increased proportion of sp²-hybridised C, relative to pure diamond, being electrically conductive and the surface (9) having a termination and/or comprising in addition particles which reduce the surface tension.

2. Micromechanical component (3) according to claim 1, **characterised in that** the top layer (2) consists of predominantly sp²-hybridised C.

3. Micromechanical component (3) according to claim 1, **characterised in that** the top layer (2) is a gradient layer which, starting from pure diamond, changes, in the direction of the outer surface (10) of the top layer (2), into a predominantly sp²-hybridised C.

4. Micromechanical component (3) according to at least one of the claims 1 to 3, **characterised in that** the top layer (2) has a Vickers hardness HV 10 < 9.8 x 10³ N/mm².

5. Micromechanical component (3) according to at least one of the claims 1 to 4, **characterised in that** the surface (9) is in addition doped, preferably boron-doped.

6. Micromechanical component (3) according to at least one of the claims 1 to 5, **characterised in that** the termination is an H-termination.

7. Micromechanical component (3) according to at least one of the claims 1 to 6, **characterised in that** the surface (9) has a roughness Rms of 5 nm to 500 nm.

8. Micromechanical component (3) according to one of the preceding claims, **characterised in that** the basic body (1) consists of Si.

9. Micromechanical component (3) according to at least one of the preceding claims, **characterised in that** the diamond has a modulus of elasticity of 400 to 1,200 GPa and/or a breaking elongation in the transverse rupture test of 1 to 10 GPa.

10. Micromechanical component (3) according to one of the preceding claims, **characterised in that** the diamond is nanocrystalline and has an average grain size of 3 to 100 nm.

11. Micromechanical component according to at least one of the claims 1 to 10, **characterised in that** it is a timepiece mechanism component.

12. Micromechanical component according to claim 11, **characterised in that** the component is a bearing component, timepiece movement, escapement component, spring, microball bearing, instrument bearing of a timepiece mechanism.

13. Micromechanical component according to at least one of the claims 1 to 10, **characterised in that** it is a microgear, microdrive, micrometer, instrument bearing, microregulator or a microactuator.

## Revendications

1. Composant micromécanique (3), qui peut être amené en contact avec un partenaire de friction, comportant un corps de base (1), ainsi qu'une surface (9), qui ferme le corps de base (1) et qui est réalisée en diamant avec un carbone hybridé sp³, une couche de finition (2), qui peut être amenée en contact avec un partenaire de friction, étant appliquée sur la surface (9),
ladite couche de finition (2) étant constituée d'une couche de carbone avec une proportion élevée de C hybridé sp² par rapport au diamant pur, ladite couche étant électroconductrice, et ladite surface (9) comportant une terminaison et/ou contenant, en plus, des particules qui diminuent la tension superficielle.

2. Composant micromécanique (3) selon la revendication 1, **caractérisé en ce que** la couche de finition (2) est constituée majoritairement de C hybridé sp².

3. Composant micromécanique (3) selon la revendication 1, **caractérisé en ce que** la couche de finition (2) est une couche de gradient qui varie en allant vers la surface extérieure (10) de la couche de finition (2), en partant du diamant pur jusqu'à un C majoritairement hybridé sp².

4. Composant micromécanique (3) selon l'une au moins des revendications 1 à 3, **caractérisé en ce que** la couche de finition (2) possède une dureté Vickers HV 10 < 9,8 x 10³ N/mm².

5. Composant micromécanique (3) selon l'une au moins des revendications 1 à 4, **caractérisé en ce que**, en plus, la surface (9) est dopée, de préférence est dopée au bore.

6. Composant micromécanique (3) selon l'une au moins des revendications 1 à 5, **caractérisé en ce que** la terminaison est une terminaison H.

7. Composant micromécanique (3) selon l'une au moins des revendications 1 à 6, **caractérisé en ce que** la surface (9) possède une rugosité Rms de 5 nm à 500 nm.

8. Composant micromécanique (3) selon l'une quelconque des revendications précédentes, **caractérisé en ce que** le corps de base (1) est réalisé en Si.

9. Composant micromécanique (3) selon l'une au moins des revendications précédentes, **caractérisé en ce que** le diamant possède un module d'élasticité de 400 à 1200 GPa et/ou un allongement jusqu'à la rupture de 1 à 10 GPa dans l'essai de rupture par flexion.

10. Composant micromécanique (3) selon l'une quelconque des revendications précédentes, **caractérisé en ce que** le diamant est nanocristallin et possède une granulométrie moyenne de 3 à 100 nm.

11. Composant micromécanique (3) selon l'une au moins des revendications 1 à 10, **caractérisé en ce qu'**il s'agit d'un composant pour mouvement.

12. Composant micromécanique (3) selon la revendication 11, **caractérisé en ce que** le composant est un élément de palier, un rouage, un élément d'arrêt, un ressort, un micro-roulement à billes, un support d'instrument d'un mouvement.

13. Composant micromécanique (3) selon l'une au moins des revendications 1 à 10, **caractérisé en ce qu'**il s'agit d'un micro-engrenage, d'un micro-entraînement, d'un micromètre, d'un support d'instrument, d'un micro-organe ou d'un micro-actionneur.
